# EUROPÄISCHE PATENTSCHRIFT

(11) **EP 1 274 288 B1**
(45) Veröffentlichungstag und Bekanntmachung des Hinweises auf die Patenterteilung: **09.03.2005**
(21) Anmeldenummer: 01130189.2
(22) Anmeldetag: 19.12.2001
(51) Int. Cl.: H05K 3/10

(54) **Leiterbahnstrukturen und Verfahren zu ihrer Herstellung**
Conducting path structures and method of making
Structures de traces conductrices et procédé de fabrication

(30) Priorität: 05.07.2001 DE 10132092
(43) Veröffentlichungstag der Anmeldung: 08.01.2003
(73) Patentinhaber: LPKF Laser & Electronics AG, 30827 Garbsen (DE)
(72) Erfinder: Naundorf, Gerhard, Prof. Dr., 32657 Lemgo (DE); Wissbrock, Horst, Prof. Dr., 32760 Detmold (DE)
(74) Vertreter: Scheffler, Jörg, Dipl.-Ing.

(56) Entgegenhaltungen:
- EP-A- 0 180 101
- EP-A- 0 340 997
- DE-A- 19 723 734
- DE-A- 19 731 346
- US-A- 4 159 414
- US-A- 4 604 303

## Beschreibung

Die Erfindung betrifft Leiterbahnstrukturen auf einem elektrisch nichtleitenden Trägermaterial gemäß dem Oberbegriff des Anspruchs 1 und ein Verfahren zu deren Herstellung.

Durch die Patentanmeldungen DE 197.23 734.7-34 und DE 197 31 346.9 sowie durch den Sonderdruck "Feinstrukturierte Metallisierung von Polymeren" aus Heft Nr. 11, 54. Jahrgang (2000) der Fachzeitschrift metalloberfläche" sind Verfahren bekannt geworden, bei denen zur Herstellung feiner, festhaftender Leiterbahnstrukturen in ein nichtleitendes Trägermaterial nichtleitende Metallchelatkomplexe eingebracht und von diesen mittels Laserstrahlung strukturiert Metallisierungskeime abgespalten werden, die in den bestrahlten Teilflächen eine nachfolgende chemisch reduktive Metallisierung initiieren.

Derartige Verfahren sind u. a. einsetzbar für die Herstellung von Schaltungsträgem aus thermoplastischen Kunststoffen mittels eines Spritzgießverfahrens. Gegenüber alternativen Verfahren zur Herstellung von dreidimensionalen Spritzguß-Schaltungsträgern, sogenannten "Moulded Interconnect Devices", weisen diese Verfahren den Vorteil auf, daß die Werkzeugkosten vergleichsweise niedrig gehalten werden können. Außerdem kann die Zahl der erforderlichen Prozeßschritte verringert werden, da der unzersetzte Metallchelatkomplex in den nicht bestrahlten Bereichen auf der Oberfläche des Schaltungsträgers verbleiben kann. Es ist so eine sehr wirtschaftliche Herstellung auch mittelgroßer Stückzahlen möglich, wobei eine besonders feine Auflösung des Strukturbildes erreicht werden kann.

Den genannten Vorteilen stehen die Nachteile gegenüber, daß die thermische Stabilität der beschriebenen Metallchelatkomplexe hinsichtlich der Verarbeitungstemperaturen moderner Hochtemperatur-Kunststoffe wie LCP im Grenzbereich liegt. Deshalb ist das Verfahren auf diesen mit der zukünftigen bleifreien Löttechnik noch wichtiger werdenden Werkstoffbereich nur beschränkt anwendbar. Zum anderen müssen die Metallchelatkomplexe in vergleichsweise hoher Dosierung zugesetzt werden, um bei Laseraktivierung eine hinreichend dichte Bekeimung für schnelle Metallisierung zu erhalten. Der hohe Komplexanteil beeinträchtigt aber häufig wichtige Gebrauchseigenschaften des Trägermaterials, wie beispielsweise die Bruchdehnung und die Schlagzähigkeit.

Im Tätigkeitsbericht 1999 des LFT der Universität Erlangen-Nürnberg ist im übrigen ein analoger Verfahrensansatz bekanntgeworden, bei dem durch Laserstrahlung freizusetzende Metallisierungskeime nicht wie oben beschrieben chemisch eingebunden, sondern physikalisch, durch Verkapselung von Metallpartikeln, passiviert werden. Da die verkapselten Partikel erheblich größer sind als die Moleküle eines typischen Metallchelatkomplexes, führt der Zielkonflikt "geringe Beimengung im Kunststoff - hohe Keimdichte nach Laserbestrahlung" hier zu erheblich größeren Problemen als bei der Bekeimung über laserspaltbare Metallchelatkomplexe.

Aufgabe der Erfindung ist es, einfach und sicher herzustellende Leiterbahnstrukturen auf Schaltungsträgem zur Verfügung zu stellen, die einen vergleichsweise geringen Anteil keimbildende Zusätze enthalten und zudem auch bei Löttemperaturen stabil sind und ferner ein einfaches und sicheres Verfahren zur Herstellung von Leiterbahnstrukturen zu schaffen, wobei ein Compoundieren bzw. Spritzgießen auch Hochtemperatur-Kunststoffe möglich sein soll.

Diese Aufgabe wird durch die Merkmale des Anspruchs 1 bzw. des Anspruchs 2 gelöst. Die weiteren Ausgestaltungen der Erfindung sind den jeweiligen Unteransprüchen zu entnehmen.

Indem die elektrisch nichtleitenden Metallverbindungen von thermisch hochstabilen, in wässrigen sauren oder alkalischen Metallisierungsbädem beständigen und nicht löslichen anorganischen Metallverbindungen gebildet sind, wird erreicht, daß diese auch im Umfeld der Leiterbahnstrukturen unverändert auf der Oberfläche des Trägermaterials verbleiben können. Die eingesetzten anorganischen Metallverbindungen sind derart temperaturbeständig, daß sie nach Einwirkung der Löttemperaturen stabil bleiben, d. h. nicht etwa elektrisch leitend werden und in den für die Metallisierung eingesetzten Bädern stabil bleiben.

Gemäß einer bevorzugten Ausführungsform der Erfindung ist es vorgesehen, daß mittels einer elektromagnetischen Strahlung gleichzeitig Schwermetallkeime freigesetzt sind und ein Abtrag unter Ausbildung einer haftvermittelnden Oberfläche erfolgt ist. Hierdurch ist mit einfachen Mitteln eine hervorragende Haftfestigkeit der abgeschiedenen metallischen Leiterbahnen erzielt worden.

Im Rahmen der Erfindung ist es vorgesehen, daß die anorganischen Metallverbindungen von Metallen der d- und f- Gruppe des Periodischen Systems mit Nichtmetallen gebildet sind. Derartige Metallverbindungen zeichnen sich durch eine hier vorteilhafte hohe Temperaturbeständigkeit aus.

In weiterer Ausgestaltung ist es vorgesehen, daß die anorganischen Metallverbindungen Metalloxide sind. Vorzugsweise sind die Metalloxide Monoxide der d-Metalle des Periodischen Systems. Vorteilhaft kann es sein, wenn die Metalloxide höhere Oxide sind. Gemäß einer bevorzugten Ausführungsform der Erfindung kann es auch vorgesehen sein, daß die höheren Oxide Spinelle sind.

Weiterhin kann es vorteilhaft sein, wenn die anorganischen Metallverbindungen Kupfer enthalten.

Gemäß einer bevorzugten Ausführungsform der Erfindung ist es vorgesehen, daß das nichtleitende Trägermaterial neben wenigstens einer anorganischen Metallverbindung wenigstens einen organischen thermisch stabilen Metallchelatkomplex enthält.

Vorzugsweise ist das elektrisch nichtleitende Trägermaterial ein thermoplastischer oder ein duroplastischer Kunststoff. Das nichtleitende Trägermaterial kann einen oder mehrere anorganische Füllstoffe enthalten, die beispielsweise von Kieselsäure und/oder Kieselsäurederivaten gebildet sind.

Bei dem erfindungsgemäßen Verfahren ist dadurch, daß eine thermisch hochstabile, in wäßrigen sauren oder alkalischen Metallisierungsbädem beständige und nicht lösliche anorganische Metallverbindung in das Trägermaterial eingemischt wird, daß das Trägermatereal zu Bauteilen verarbeitet oder auf Bauteile als Beschichtung aufgetragen wird und daß im Bereich der zu erzeugenden Leiterbahnstrukturen mittels einer elektromagnetischen Strahlung Schwermetallkeime freigesetzt und diese Bereiche dann chemisch reduktiv metallisiert werden, insbesondere auch erreicht worden, daß die anorganische Metallverbindung auch in den nicht bestrahlten Bereichen auf der Oberfläche des Trägermaterials vierbleiben kann. Die eingesetzten anorganischen Metallverbindungen sind im übrigen derart temperaturbeständig, daß ein Compoundieren bzw. Spritzgießen auch moderner Hochtemperatur-Kunststoffe möglich ist. Außerdem bleiben diese auch nach Einwirkung der Löttemperaturen stabil, d. h. sie werden nicht etwa elektrisch leitend und bleiben in den für die Metallisierung eingesetzten Bädern stabil.

Gemäß einer bevorzugten Ausführungsform der Erfindung ist es vorgesehen, daß mittels der elektromagnetischen Strahlung gleichzeitig Schwermetallkeime freigesetzt sind und ein Abtrag unter Ausbildung einer haftvermittelnden Oberfläche erfolgt ist. Hierdurch kann mit einfachen Mitteln eine hervorragende Haftfestigkeit der abgeschiedenen metallischen Leiterbahnen erzielt werden.

Im Rahmen der Erfindung ist es vorgesehen, daß die anorganischen Metallverbindungen von Metallen der d- und f- Gruppe des Periodischen Systems mit Nichtmetallen gebildet sind. Derartige Metallverbindungen zeichnen sich durch eine hier vorteilhafte hohe Temperaturbeständigkeit aus.

Weiterhin kann es vorteilhaft sein, wenn die anorganischen Metallverbindungen Kupfer enthalten.

Gemäß einer bevorzugten Ausführungsform der Erfindung ist es vorgesehen, daß das nichtleitende Trägermaterial neben wenigstens einer anorganischen Metallverbindung wenigstens einen organischen thermisch stabilen Metallchelatkomplex enthält.

Vorzugsweise ist das nichtleitende Trägermaterial ein thermoplastischer oder ein duroplastischer Kunststoff. Das Trägermaterial kann jedoch durchaus auch von anderen geeigneten nichtleitenden Materialien wie z. B. von einem Keramikwerkstoff gebildet sein. Das nichtleitende Trägermaterial kann im übrigen einen oder mehrere anorganische Füllstoffe enthalten, die beispielsweise von Kieselsäure und/oder Kieselsäurederivaten gebildet sind.

Vorteilhaft ist es, wenn zur Freisetzung der Schwermetallkeime die elektromagnetische Strahlung eines Lasers eingesetzt wird. Die Wellenlänge des Lasers kann vorzugsweise 248 nm, 308 nm, 355nm, 532 nm, 1064nm oder auch 10600 nm betragen.

Im folgenden wird die Erfindung an einem Ausführungsbeispiel erläutert:
Es werden in einem Extruder 70 Masseteile Polybuthylentherephthalat, 25 Masseteile einer pyrogenen Kieselsäure mit einer BET-Oberfläche von 90 m²/g und 5% des kupferhaltigen Spinells PK 3095 der Firma Ferro GmbH compoundiert. Das Granulat wird im Spritzgießverfahren zu einem Bauteil, z. B. dem Gehäuse eines Handys verarbeitet. Das Gehäuse wird dann im Bereich der aufzubringenden Leiterbahnen einer Laserstrahlung, die von einem diodengepumpten Nd:YAG-Laser erzeugt wird, mit einer Intensität bestrahlt, die einen geringfügigen Abtrag erzeugt, der mit einer strukturierten Bekeimung verbunden ist. Nach kurzer Behandlung in einem demineralisiertes Wasser enthaltenden Ultraschall-Reinigungsbad wird das Gehäuse in ein handelsübliches chemisch reduktives Verkupferungsbad gehängt. Hier werden in den bestrahlten Bereichen die Leiterbahnen aufgebaut.

Grundsätzlich ist zu bemerken, daß in der Fachwelt einfache anorganische Verbindungen von Metallen und Nichtmetallen wie Karbide, Nitride, Oxide oder Sulfide als stabil und als nur unter hoher Energiezufuhr bei gleichzeitiger Anwesenheit eines reduzierenden Mediums in elementares Metall überführbar gelten. Unter Umgebungsatmosphäre wird darüber hinaus, vor allem bei Nichtedelmetallen, eine sofortige Reaktion eventuell entstehenden Metalls mit dem Luftsauerstoff zu Metalloxid erwartet. Um so überraschender ist die erfindungsgemäße Erkenntnis, daß beispielsweise Metalloxide, die feinstverteilt in eine Kunststoffmatrix eingebettet sind, unter gewöhnlicher Umgebungsatmosphäre mit einem Nd:YAG-Laser freigelegt und zu Metall reduziert werden können. Offenbar entfalten die sich gleichzeitig bildenden gasförmigen Zersetzungsprodukte des Kunststoffes während der sehr energiereichen, aber auch sehr kurzen Laserpulse eine hinreichende Abschirmungswirkung über den entstandenen Metallkeimen.

## Patentansprüche

1. Leiterbahnstrukturen auf einem nichtleitenden Trägermaterial, die aus Metallkeimen und einer nachfolgend auf diese aufgebrachten Metallisierung bestehen, wobei die Metallkeime durch Aufbrechen von feinstverteilt in dem Trägermaterial enthaltenen nichtleitenden Metallverbindungen entstanden sind, **dadurch gekennzeichnet, daß** die nichtleitenden Metallverbindungen von thermisch hochstabilen, in wässrigen sauren oder alkalischen Metallisierungsbädem beständigen und nicht löslichen anorganischen Metallverbindungen gebildet sind, die den Bereichen im Umfeld der Leiterbahnstrukturen unverändert auf dem Trägermaterial verblieben sind.

2. Verfahren zur Herstellung der Leiterbahnstrukturen nach Anspruch 1, **dadurch gekennzeichnet, daß** eine thermisch hochstabile, in wässrigen sauren oder alkalischen Metallisierungsbädem beständige und nicht lösliche anorganische Metallverbindung in das Trägermaterial eingemischt wird, daß das Trägermaterial zu Bauteilen verarbeitet oder auf Bauteile als Beschichtung aufgetragen wird und daß im Bereich der zu erzeugenden Leiterbahnstrukturen mittels einer elektromagnetischen Strahlung Schwermetallkeime freigesetzt und diese Bereiche dann chemisch reduktiv metallisiert werden.

3. Verfahren nach Anspruch 2, **dadurch gekennzeichnet, daß** mittels der elektromagnetischen Strahlung gleichzeitig die Schwermetallkeime freigesetzt werden und ein Abtrag unter Ausbildung einer haftvermittelnden Oberfläche erfolgt.

4. Verfahren nach Anspruch 2, **dadurch gekennzeichnet, daß** die anorganischen Metallverbindungen von Metallen der d- und f- Gruppe des Periodischen Systems mit Nichtmetallen gebildet sind.

5. Verfahren nach den Anspruch 2, **dadurch gekennzeichnet, daß** die anorganischen Metallverbindungen Metalloxide sind.

6. Verfahren nach Anspruch 5, **dadurch gekennzeichnet, daß** die Metalloxide Monoxide der d-Metalle des Periodischen Systems sind.

7. Verfahren nach Anspruch 5, **dadurch gekennzeichnet, daß** die Metalloxide höhere Oxide sind.

8. Verfahren nach Anspruch 7, **dadurch gekennzeichnet, daß** die höheren Oxide Spinelle sind.

9. Verfahren nach zumindest einem der Ansprüche 2 bis 8, **dadurch gekennzeichnet, daß** die anorganischen Metallverbindungen Kupfer enthalten.

10. Verfahren nach zumindest einem der Ansprüche 2 bis 9, **dadurch gekennzeichnet, daß** das nichtleitende Trägermaterial neben wenigstens einer anorganischen Metallverbindung wenigstens einen organischen thermisch stabilen Metallchelatkomplex enthält.

11. Verfahren nach zumindest einem der Ansprüche 2 bis 10, **dadurch gekennzeichnet, daß** das nichtleitende Trägermaterial ein thermoplastischer oder ein duroplastischer Kunststoff ist.

12. Verfahren nach zumindest einem der Ansprüche 2 bis 11, **dadurch gekennzeichnet, daß** das nichtleitende Trägermaterial einen oder mehrere anorganische Füllstoffe enthält.

13. Verfahren nach Anspruch 12, **dadurch gekennzeichnet, daß** das nichtleitende Trägermaterial als Füllstoff Kieselsäure und/oder Kieselsäurederivate enthält.

14. Verfahren nach zumindest einem der Ansprüche 2 bis 13, **dadurch gekennzeichnet, daß** die elektromagnetische Strahlung eines Lasers eingesetzt wird.

15. Verfahren nach Anspruch 14, **dadurch gekennzeichnet, daß** elektromagnetische Strahlung eines Lasers mit einer Wellenlänge von 248 nm, 308 nm, 355 nm, 532 nm, 1064 nm oder 10600 nm eingesetzt wird.

## Claims

1. Conductor track structures on a non-conductive carrier material, which comprise metal seeds and a metallisation subsequently applied thereto, the metal seeds having been produced by breaking open finely distributed non-conductive metal compounds contained in the carrier material, **characterised in that** the non-conductive metal compounds are formed by thermally highly stable inorganic metal compounds which are unchanging and insoluble in aqueous acidic or alkaline metallisation baths, the compounds being left unchanged on the carrier material in the regions in the surroundings of the conductor track structures.

2. Method for producing the conductor track structures according to claim 1, **characterised in that** a thermally highly stable inorganic metal compound which is unchanging and insoluble in aqueous acidic or alkaline metallisation baths is mixed into the carrier material, **in that** the carrier material is processed to form components or is applied as a coating to components, and **in that**, in the region of the conductor track structures to be produced, heavy metal seeds are released by means of electromagnetic radiation and these regions are then chemically reductively metallised.

3. Method according to claim 2, **characterised in that** the heavy metal seeds are released and at the same time erosion with formation of an adhesion-promoting surface takes place by means of the electromagnetic radiation.

4. Method according to claim 2, **characterised in that** the inorganic metal compounds are formed by metals of the d and f groups of the periodic table and non-metals.

5. Method according to claim 2, **characterised in that** the inorganic metal compounds are metal oxides.

6. Method according to claim 5, **characterised in that** the metal oxides are monoxides of the d-metals of the periodic table.

7. Method according to claim 5, **characterised in that** the metal oxides are higher oxides.

8. Method according to claim 7, **characterised in that** the higher oxides are spinels.

9. Method according to at least one of claims 2 to 8, **characterised in that** the inorganic metal compounds contain copper.

10. Method according to at least one of claims 2 to 9, **characterised in that** the non-conductive carrier material contains at least one organic thermally stable metal chelate complex in addition to at least one inorganic metal compound.

11. Method according to at least one of claims 2 to 10, **characterised in that** the non-conductive carrier material is a thermoplastic polymer or a thermoset plastics material.

12. Method according to at least one of claims 2 to 11, **characterised in that** the non-conductive carrier material contains one or more inorganic fillers.

13. Method according to claim 12, **characterised in that** the non-conductive carrier material contains silica and/or silica derivates as the filler.

14. Method according to at least one of claims 2 to 13, **characterised in that** the electromagnetic radiation of a laser is used.

15. Method according to claim 14, **characterised in that** electromagnetic radiation of a laser at a wavelength of 248 nm, 308 nm, 355 nm, 532 nm, 1064 nm or 10600 nm is used.

## Revendications

1. Structures de circuits imprimés sur un matériau support non conducteur, qui sont constituées de germes métalliques et d'une métallisation appliquée postérieurement sur ceux-ci, les germes métalliques ayant été formés par ouverture de composés métalliques non conducteurs contenus de manière finement répartie dans le matériau support, **caractérisées en ce que** les composés métalliques non conducteurs sont formés par des composés métalliques inorganiques très stables thermiquement, résistants dans des bains de métallisation aqueux acides ou alcalins et non solubles qui sont restés inchangés sur le matériau support dans les zones de l'entourage des structures de circuits imprimés.

2. Procédé pour fabriquer les structures de circuits imprimés selon la revendication 1, **caractérisé en ce qu'**un composé métallique inorganique très stable thermiquement, résistant dans des bains de métallisation aqueux acides ou alcalins et non soluble est mélangé au matériau support, que le matériau support est usiné en composants ou appliqué en couche sur des composants et que, dans la zone des structures de circuits imprimés à produire, des germes de métal lourd sont libérés au moyen d'un rayonnement électromagnétique et que ces zones sont ensuite métallisées chimiquement par réduction.

3. Procédé selon la revendication 2, **caractérisé en ce que** les germes de métal lourd sont libérés simultanément au moyen de rayonnement électromagnétique et qu'un enlèvement a lieu avec formation d'une surface adhésive.

4. Procédé selon la revendication 2, **caractérisé en ce que** les composés métalliques inorganiques sont formés par des métaux du groupe d et du groupe f du système périodique avec des métalloïdes.

5. Procédé selon la revendication 2, **caractérisé en ce que** les composés métalliques inorganiques sont des oxydes métalliques.

6. Procédé selon la revendication 5, **caractérisé en ce que** les oxydes métalliques sont des monoxydes des métaux du groupe d du système périodique.

7. Procédé selon la revendication 5, **caractérisé en ce que** les oxydes métalliques sont des oxydes supérieurs.

8. Procédé selon la revendication 7, **caractérisé en ce que** les oxydes supérieurs sont du spinelle.

9. Procédé selon au moins l'une des revendications 2 à 8, **caractérisé en ce que** les composés métalliques inorganiques contiennent du cuivre.

10. Procédé selon au moins l'une des revendications 2 à 9, **caractérisé en ce que** le matériau support non conducteur contient, à côté d'au moins un composé métallique inorganique, au moins un complexe de chélation de métal organique stable thermiquement.

11. Procédé selon au moins l'une des revendications 2 à 10, **caractérisé en ce que** le matériau support non conducteur est une matière plastique thermoplastique ou thermodurcissable.

12. Procédé selon au moins l'une des revendications 2 à 11, **caractérisé en ce que** le matériau support non conducteur contient un ou plusieurs matériaux de charge inorganiques.

13. Procédé selon la revendication 12, **caractérisé en ce que** le matériau support contient comme matériau de charge de l'acide silicique et/ou des dérivés d'acide silicique.

14. Procédé selon au moins l'une des revendications 2 à 13, **caractérisé en ce que** le rayonnement électromagnétique d'un laser est utilisé.

15. Procédé selon la revendication 14, **caractérisé en ce qu'**un rayonnement électromagnétique d'un laser d'une longueur d'onde de 248 nm, 308 nm, 355 nm, 532 nm, 1 064 nm ou 10 600 nm est utilisé.
